Europäisches Patentamt

(19) European Patent Office

Office européen des brevets

(11) Publication number: **0 244 572 B1**

# (12) EUROPEAN PATENT SPECIFICATION

(45) Date of publication of the patent specification:
05.09.90

(21) Application number: **87102191.1**

(22) Date of filing: **17.02.87**

(51) Int. Cl.⁵: **G03F 7/38, G03F 7/095**

(54) Capped two-layer resist process.

(30) Priority: **24.04.86 US 855867**

(43) Date of publication of application:
**11.11.87 Bulletin 87/46**

(45) Publication of the grant of the patent:
**05.09.90 Bulletin 90/36**

(84) Designated Contracting States:
**DE FR GB IT**

(56) References cited:
**EP-A- 0 136 130**
**EP-A- 0 161 476**
**EP-A- 0 195 291**
**DE-A- 3 133 350**
**GB-A- 2 152 223**
**US-A- 4 430 153**

**SOLID STATE TECHNOLOGY, vol. 27, no. 2,
February 1984, pages 145-155, Port Washington, New
York, US; G.N. TAYLOR et al.: "The role of inorganic
materials in dry-processed resist technology"
IBM TECHNICAL DISCLOSURE BULLETIN, vol. 27,
no. 4A, September 1984, page 2197, New York, US; H.
HIRAOKA: "Positive-tone polymer pattern fabrication
by gas phase surface modification"
IBM TECHNICAL DISCLOSURE BULLETIN, vol. 24,**

(73) Proprietor: **International Business Machines
Corporation, Old Orchard Road, Armonk, N.Y. 10504(US)**

(72) Inventor: **Lyons, Christopher Francis, 408 Beaver Road,
Lagrangeville New York 12540(US)**

(74) Representative: **Klein, Daniel Jacques Henri, Compagnie
IBM France Département de Propriété Intellectuelle,
F-06610 La Gaude(FR)**

(56) References cited: (continuation)
**no. 11B, April 1982, page 6014, New York, US; R.H.
FLACHBART et al.: "High resolution mask fabrication
process using E-beam lithography"
PATENT ABSTRACTS OF JAPAN, vol. 10,
no. 57 (P-434)[2114], 7th March 1986; &
JP-A-60 200 253 (NIPPON DENKI K.K.) 09-10-1985**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a method for producing high lithographic quality two-layer resists. More specifically, this invention relates to a method where the top layer of the two-layer resist is rendered dry etch and solvent resistant. Even further, this invention provides a method for accurate production of capped two-layer resists with a vertical profile.

Because of the complexity and miniaturization of electronic components such as integrated circuits, the art has basically moved from the use of single-level resist processing techniques to multi-level resist systems due to problems associated with wafer topography and surface reflectivity.

Numerous two- and three-level resist processes are known in the art and are used in order to overcome the problems associated with the use of single-level resist processes. In particular, a two-level resist process employing poly(methylmethacrylate) (PMMA) as a thick planarizing layer and novolac-naphtoquinone diazide resist as a top thin layer is known, e.g., as described in U.S. Patent 4,211,834. The portable conformable mask technology described in U.S. Patent 4,211,834 provides a method for creating topography-insensitive, micron and sub-micron sized high aspect ratio resist images without the necessity for the use of reactive ion etching (RIE).

In order to improve etch resistance in the formation of and use of resist systems, organo-metallic materials have been employed. In particular, silicon has been used, in some instances, as a part of the imaging polymer backbone and in other cases, the silicon part of a pendant group attached to the polymer backbone. The use of silicon in an organic polymer is intended to render the polymer resistant to erosion in oxygen plasmas. For example, U.S. Patent 4 396 704, describes the creation of a resist film which comprises at least one type of organometallic monomer and a host polymer. The disclosure is that the organometallic monomer may contain silicon and typically, the host polymer contains a halogen. The resist is irradiated to react the organometallic monomer and to lock it into place in the irradiated area. Residual organometallic monomer is subsequently removed from the irradiated areas by heating the resist in a vacuum. The resist is then transferred from the irradiated portion of the imaging layer of the resist to underlying layers using oxygen reactive ion etching.

A similar disclosure is made in EP-A 136 130 which describes the use of a two resist layer mask. The top resist layer is of the wet developable type and is UV exposed and developped. The remaining portions are hardened by contact with an organometallic gas and is used as mask to delineate the bottom resist layer of the dry developable type.

GB-A 2 152 223 describes a bi-resist layer process with no hardening step.

U.S. Patent 4 552 833 (assigned to the assignee of this application) discloses silylation of non-silicon-containing resist films to create etch resistance. This resist material is irradiated with the creation of sites which are capable of being silylated in the resist material. A silylating agent is then reacted with the sites in the resist by contacting the resist with an organometallic compound in liquid or vapor form. This is followed by a dry development of the etch-resistant latent image and any desired adjacent polymeric resist layers.

Copending European Patent application 85115321.3, filed December 3, 1985, assigned to the assignee of this application discloses a method for converting only the upper portion of a layer of a resist into a dry-etch resistant form. The method enables the production of sub-micron line widths using an optical imaging system.

Silylation of a wet developed resist image is disclosed in copending European Patent application 86102644.1, filed February 28, 1985, assigned to the assignee of this application with etch resistance being provided during etching of underlying layers, a preferred imaging resist layer being a novolac resin, a polyvinyl phenol resin or an acrylate resin.

Multifunctional silylating agents are described in copending European Patent application 86103208.4, filed March 11, 1986, assigned to the assignee of this application as providing improved etch resistance and high temperature stability by use of polyfunctional silylating agents to produce a silylated resist.

Further, copending European Patent application 86107186.2, filed May 27, 1986, assigned to the assignee of this application discloses the formation of an etch-resist through preferential permeation. Image reversal by control of the wavelength or intensity of the radiation source is achieved. An organometallic compound is employed in order to provide, upon irradiation, an increase in the permeability of the organometallic compound in the irradiated areas.

Copending European Patent application 86 111 282.9, filed August 14, 1986, assigned to the assignee of this application) involves the exposure of a photoresist followed by reaction of such with an organosilicon compound. Subsequently, the latent image formed is dry developed.

While each of the above techniques provides improvement in resist production, simpler processing is desired in the ability to produce resist images.

Specifically, processes for producing capped undercut profiles and uncapped vertical profiles in bi-level resist systems are known in the prior art yet there has been no practical approach to the use of a process to produce a capped vertical profile resist image without the use of RIE.

Although deep U.V. bi-level resist processes are well suited to achieving high resolution lithography over the complex surface of an integrated surface, application of these techniques in subtractive etching processes have been limited by the poor etch resistance of the available planarizing layers on the substrate. Known uncapped bi-level processes are quite good for producing vertical profiles but the resulting resist images lack the etch resistance needed for a process involving the plasma etching of underlying substrates such as aluminum alloys. Known methods of creating capped vertical profile resist images involve complicated process sequences including additional coatings, stringently controlled baking procedures, plasma etching, and the like, and do not involve simple systems.

## Summary of the Invention

An object of this invention is to provide an improved method for production of a resist image.

A further object of this invention is to provide a simple processing technique for the production of a resist image.

An even further object of this invention is to provide a process for the production of a resist image in which wet development techniques can be employed with the production of an accurate capped two-layer resist having a vertical profile, or a lift-off (inverted) profile.

A further object of this invention is to provide a process which is capable of producing excellent images in a film-layer resist.

Accordingly, in one embodiment of this invention, this invention provides a method of producing a resist image comprising:

(a) providing a substrate with a layer of a wet developable resist material as a bottom resist layer and with a layer of a wet developable resist material as a top resist layer, wherein
    (i) the sensitivity to radiation of the resist material of the top resist layer differs significantly from the sensitivity to radiation of the resist material of the bottom resist layer, and
    (ii) the resist material of the top resist layer contains sites capable of reacting with a silylating agent;

(b) imagewise exposing to radiation the top resist layer, the imagewise exposing of the top resist layer being such that the bottom resist layer is substantially unaffected by the imagewise exposing;

(c) wet developing the top resist layer to produce a top layer resist image;

(d) reacting the developed top resist layer with a silylating agent to produce an etch resistant pattern of the top resist layer on the bottom resist layer and also to render the top resist layer resistant to the development to be used for subsequent development of the bottom resist layer;

(e) exposing the bottom resist layer through the top layer resist layer to radiation capable of rendering the resist material of the bottom resist layer in the exposed areas developable; and

(f) developing the exposed bottom resist layer to uncover the substrate in the imagewise exposed and developed areas.

After reacting the developed top resist layer with a silylating agent in step (d) above, the method of this invention in step (f) includes wet development of or dry etch development of the wet developable bottom resist layer.

## Detailed Description of the Invention

In the method of this invention, a resist image material comprising a substrate having thereon a bottom layer of a resist material and thereon a top layer of a resist material is employed. More specifically, a substrate, such an oxidized silicon wafer, is first coated with a uniform layer of the resist material for the bottom resist layer in a thickness of about 0.5 to 5 μm, preferably 1 to 3 μm, using conventional coating techniques such as spin coating followed by drying. This is then followed by coating the bottom resist layer with a layer of the resist material for the top layer in a thickness of about 0.2 to about 2.0 μm, preferably 0.5 to 1.0 μm. A suitable technique for coating the top resist layer on the bottom resist layer includes spin coating, followed by drying.

Suitable examples of wet-developable resists which can be used as resist materials in this invention for the top layer are solvent developable and aqueous base developable resist materials. Generally, aqueous base developable resist materials are used and examples include aqueous-based developable novolac resins, including novolac resins, for example, the condensation products of phenol or alkyl ($C_1$-$C_6$) substituted and halogen-substituted phenols (e.g., cresoles, etc.), resorcinols, pyrogallol, etc., with aldehydes or aldehyde precursors such as formaldehyde, acetaldehyde, acetone, acrolein, benzaldehyde, 1,3,5-trioxane and also addition polymers of hydroxystyrene and the like. Suitable aqueous-based developable resins which can be used are those with molecular weights of about 1000 to 100 000, preferably 5 000 to 50 000.

The novolac resin compositions which can be used to produce the novolac based top resist layer employed in these embodiments of this invention generally include a photosensitizer, e.g., of the 1,2-diazonaphthoquinone-5-sulfonate type, such as the 1-oxo-2-diazon-naphthalene-5-sulfonic acid ester of 2,3,4-trihydroxybenzophenone, e.g., as disclosed in U.S. Patents 3 046 118, 3 046 121, 3 106 465; 3 201 239; 3 666 473, to increase sensitivity to the radiation of exposure. Suitable commercially available novolac-based U.V. photoresists of this type are AZ 1350 (trade name for a resist comprising a novolac resin and a diazoquinone photosensitizer commercially available from Hunt Chemical). Other resists utilizing different combinations of novolac reins and different photosensitizers can be employed, if desired, in this invention. For example, a novolac resist with a polyolefin sulfone sensitizer, e.g., as described in U.S. Patent 4 398 0001, polymethylallyl ether-methyl pentene sulfone bipolymer can be employed. A commercially available example of this class of novolac composition is RE 5000P (trade name for an electron beam resist comprising a novolac resin and poly-2-methyl pentene sulfone commercially available from Hitachi). Poly(p-hydroxystyrene) resins with azido sensitizers as in commercially available Hitachi RD2000N, RU1000N and R63000N can also be used.

Suitable resist materials which can be used as the bottom resist layer of the mask material employed in the process of this invention include those materials which are soluble in organic solvent developers and those materials which are soluble in aqueous-base developers.

More specifically suitable examples of resist materials developable in organic solvent developers which can be used in this invention include polymethylmethacrylate (PMMA) polymers, polymethylisopropenyl ketone, poly-t-butyl methacrylates and other polymethacrylate copolymers.

Exemplary materials developable in aqueous base developers which can be employed in this invention as the bottom resist layer sensitive to radiation in the deep U.V. range include methacrylate terpolymers such as methyl methacrylate (MMA)/methacrylic acid (MAA)/methacrylic anhydride (MAAM) terpolymer (e.g., as disclosed in U.S. Patent 3 087 659); aliphatic imide polymers such as polydimethyl glutarimide; other acrylic acid polymers; polymethyl methacrylate/methacrylic acid polymers; itaconic acid polymers such as poly-dimethyl itaconic acid; and poly(hydroxystyrene). Desirably, the resist materials for the bottom layer of the resist material used in the process of this invention will have appropriate solubility characteristics that the top layer of resist material can be coated on the bottom layer with no substantial alteration in the bottom layer. A preferred resist material for the bottom layer is a resist material sensitive to deep U.V. radiation, e.g., in a range of about 200 nm to about 300 nm, more preferably 200 nm to 250 nm, and representative examples of such are given above.

Both positive and negative resist materials can be used for the top resist layer, as desired, such as azide-polyvinyl phenols (e.g., as disclosed in U.S. Patents 4 268 603, 4 148 655, etc..) (such as RG3000N and RD2000N available from Hitachi Chemical), diazoquinone phenolics or novolacs (such as AZ 1350 available from Azoplate), etc.

Where desired, the bottom resist layer can be dyed, e.g., with a dye, for anti-reflection purposes. Suitable characteristics of this dye are thermal stability and ability to absorb the wavelength of the radiation, e.g., U.V. radiation, used for top layer resist imagewise exposure.

Suitable specific examples include coumarin dyes such as coumarin 6, coumarin 7 and coumarin 30 available from Kodak.

Specific examples of aqueous base developable resist materials which can be used in the resist layers of the resist material used in this invention include diazoquinone derivative sensitized novolac resins. Examples of suitable resist materials which comprise polyvinyl phenol and bis aryl azides are described in U.S. Patent 4,268,603. Examples of polymers converted to a polyvinyl phenol upon irradiation and thermal treatment in the presence of an aryl onium salt photoactive component are poly(p-tert-butoxycarbonyloxystyrene), poly(tert-butyl p-vinylbenzoate), poly(p-tert-butoxycarbonyloxy-2-methylstyrene), poly(tert-butyl p-isopropenyloxyacetate), and poly(tert-butyl metalcrylate), e.g., as disclosed in U.S. Patent 4,491,628.

Suitable resist materials for the bottom layer of the imaging material which can be used in the process of this invention include a polymer where at least portions of the polymer are selected from the group consisting of:

(1) a polymer which contains a carboxylic acid group and which upon irradiation becomes aqueous-base developable, such as a terpolymer of methyl methacrylate, methacrylic acid and methacrylic anhydride;

(2) a polymer comprising an acid anhydride group wherein upon irradiation the anhydride hydrolyzes, or after irradiation, in the presence of the aqueous base developer, the anhydride hydrolyzes to provide an acid, such as copolymers of methacrylic anhydride and acrylic anhydride;

(3) a polymer comprising an imide group which upon irradiation becomes aqueous-base developable, such as a polyglutarimide and a polymaleimide; and

(4) a polymer which upon irradiation generates a phenolic group, a hydroxy group or an imide group such as o-nitrobenzaldehyde derivatives, polymers capable of photo-Fries rearrangement, and the onium salt-"t-boc" system in U.S. Patent 4,491,628.

The onium salt-"t-boc" system described in U.S. Patent 4,491,628 can also be used as the resist for the top layer of the resist image material used in the process of this invention.

As to the difference in sensitivity to radiation (which can be a difference in sensitivity to radiation of different wavelength ranges or a difference in the degree of sensitivity to radiation in the same wavelength range), the resist material of the top layer can be sensitive to radiation in the wavelength range of about 300 to about 500 nm or have a relative sensitivity to radiation of about 1 while the resist material of the bottom layer has a sensitivity to radiation in the wavelength range of less than about 300 nm or has a relative sensitivity to radiation of about 10 to about 1000, preferably 100 to 1000. Chain scission polymer resists typically show a sensitivity of 1-3 orders of magnitude less than sensitized polymers. For example, a resist layer structure of the resist material which can be used in the process of this invention can be a "t-boc" resist (about 5 mj/cm²) as a top layer on a methacrylate terpolymer, (about 5000 mj/cm²) as described therinbefore, as a bottom layer and this provides suitable differential sensitivity to radiation.

Various sensitizers can be used to enhance the radiation sensitivity of the polymers suitable for in this invention, but use of a sensitizer is not necessary in most cases, since with the exception of the onium salt-"t-boc" polymers of the group - (4), the bottom layer polymers described above are per se photosensitive.

The mask material which can be used in embodiments of this invention can be easily prepared using the above-described materials.

After the mask material employed in the process of this invention is produced, the material is then exposed in an imagewise manner, e.g., using a chrome-on-glass master as an image, to radiation to which the resist material of the top resist layer is sensitive. A suitable wavelength of the radiation used for this exposure ranges from about 300 nm to about 450 nm, preferably 313 nm to 436 nm. Suitable sources of radiation which can be used for exposure to wavelengths in this range include a mercury lamp, a mercury-xenon lamp, etc. Alternatively, the top layer can be imagewise exposed to electron beam radiation or X-rays. Use of electron beams or X-rays for this exposure step is advantageous where the top resist layer and the bottom resist layer are differentially sensitive to radiation in the same wavelength range.

After this imagewise exposure of the top resist layer, the mask material is then developed in a wet developer such as an organic solvent or using an aqueous base developer, e.g., having a pH of about 12 to about 13. In a preferred embodiment of this invention, the top resist layer is rendered developable in an aqueous base developer. Suitable examples of aqueous base developers which can be used in this invention include aqueous solutions of potassium hydroxide, sodium hydroxide, tetramethyl ammonium hydroxide, sodium silicate, sodium phosphate, etc. These aqueous base developers are commercially available as AZ Developer from Azoplate and Microposit 2401 from Shipley. The exposed areas of the top resist layer as a result of the imagewise exposure to radiation are rendered soluble in the wet developer and upon contact therewith are removed uncovering, in those areas removed, the bottom resist layer lying thereunder. Naturally, which areas are removed in this development will be dependent on whether the top resist layer is a positive resist or a negative resist.

As a result of this exposure and development of the top resist layer, a mask image corresponding to the original image used for exposure is formed in the top layer to form a mask for the bottom resist layer lying under the top layer.

In the next step of the process of this invention, the mask material having thereon the exposed and developed top resist layer is reacted with a silylating agent to produce an etch resistant pattern on the bottom resist layer and also to render the top resist layer resistant to the developer to be used for subsequent development of the bottom resist layer.

Suitable examples of silylating agents which can be employed include hexamethylcyclotrisilizane (HMCTS), and other multifunctional silazanes. A preferred silylating agent is hexamethylcyclotrisilizane.

This silylating step can be achieved by direct contact with the silylating agent in the form of a vapor or in the form of a solution, e.g., at a concentration of silylating agent of about 0.1 to about 25% by weight, more preferably 5 to 15% by weight. Suitable examples of solvents which can be employed when a solution of the silylating agent is used in this step include xylene, benzene, toluene, and hexane. In this step, the silylating agent reacts with the developed top resist layer for a period of time sufficient to render the top resist layer etch resistant under the conditions of etching to be subsequently used and also sufficiently resistant to the developer solution to be used for subsequent development of the bottom resist layer. The time and temperature required to achieve the silylation of the top resist layer image can be routinely determined by one skilled in the art but in general will range from about 1 minute to about 30 minutes, more generally about 5 minutes to about 15 minutes at a temperature of about 30°C to about 80°C, more preferably 40°C to 70°C. Suitably, the time of contact can be about 10 minutes per micron of resist layer thickness within the concentration ranges described above. This provides for sufficient silylation.

As a result of the reaction of the pattern image formed in the developed top resist layer with the silylating agent at the sites in the resist material reactive with this agent, this image pattern remaining becomes an etch resistant pattern and simultaneously becomes also a pattern which is resistant to the developer to be used for subsequent development of the bottom resist layer.

In the next step of the process of this invention, the resist image material is exposed to radiation capable of rendering the resist material of the bottom resist layer soluble in the developer to be used for the bottom resist layer. As a result of this exposure through the image containing top resist layer, image areas are created in the bottom resist layer which are rendered developable and a developer, in the next step of the process of this invention, is employed for development.

Suitable examples of organic solvent type developers which can be used for development of the bottom resist layer include methoxyethanol, ethoxyethanol, methyl isobutyl ketone and other solvents or solvent mixtures.

The development of the bottom resist layer with an organic solvent developer can be achieved at a temperature of about 10°C to 24°C, and a sufficient development time ranges from about 10 seconds to about 120 seconds, more generally 30 seconds to 60 seconds.

A particularly advantageous exposure to radiation for the bottom resist layer involves exposure to deep U.V. radiation. For example, where a thin top resist layer with an image therein is formed, the resulting image mask can be exposed to radiation having a wavelength of about 200 to about 300 nm, preferably 200 to 240 nm at room temperature. Specifically, a blanket exposure of the underlying bottom resist layer can be used since the image pattern in the top resist is a mask for the exposure to radiation of the bottom resist layer. Suitable sources providing radiation in this wavelength include a mercury-xenon lamp, a mercury lamp, and the like.

As a result of this exposure step, the bottom resist layer is rendered developable. Where the bottom resist layer is developable in an aqueous-based developer, suitable aqueous-based developers which can be used are those having a pH in the range of about 12 to about 13. Exemplary aqueous-based developers which can be used include aqueous solutions of sodium hydroxide, potassium hydroxide, tetramethyl ammonium hydroxide, sodium phosphate and sodium silicate. A suitable time and temperature for this development ranges from about 1 minute to about 10 minutes at about 10°C to about 25°C, respectively.

Alternatively, a dry etch development of the bottom resist layer can be employed, if desired, instead of a wet development of the bottom resist layer.

As a result of the procedures described above and employed in the process of this invention, a mask on the underlying substrate is thereby formed.

The following examples are given to illustrate the process of the present invention in greater detail. However, these examples are not to be construed as limiting the scope of the present invention. Unless otherwise indicated herein, all parts, percents, ratios, and the like are by weight.

Example 1

Silicon wafers having a thermally grown $SiO_2$ layer about 5000 Å in thickness were spin coated with a solution of a terpolymer of MMA, MAA, MAAN (molar ratio 65:25:10) dissolved in diglyme to obtain a thickness of about 2 micrometers after baking at 200°C for 60 minutes. A second (image layer) resist comprising a novalac resin and a naphthoquinone diazide with a solvent was then applied by spin coating to obtain a layer of a thickness of 1.0 micrometer after an 80°C/30 minute bake.

The image layer was patterned by exposure through a mask using a Mann 6300 DSW aligner (GCA Corporation) and development in aqueous KOH (0.21N) for 75 seconds.

A wafer, patterned as described above, was then immersed in a solution of hexamethyltrisilizane (5% by weight in mixed xylenes) at 65°C for 5 minutes and rinsed in xylene.

The pattern of the image layer was then transferred into the bottom resist layer using a blanket exposure to radiation of a wavelength of 200 - 240 nm to a dose of 800mj/cm² and removing the exposed (un-masked) regions of the bottom resist in a developing solution comprising 97% by volume 2-ethoxyethanol and 3% by volume $H_2O$. High quality images as small as 1 micrometer (3:1 aspect ratio) with vertical profiles were obtained.

Example 2

A silicon wafer as described in Example 1 was subjected to the procedures of Example 1 except that the blanket exposure energy was 2000 mj/cm². High quality images as small as 1 micrometer, with undercut profiles suitable for lift-off applications, were obtained.

Example 3

Silicon wafers as described in Example 1 were subjected to the procedures of Example 1 except that a mixture of methyl isobutyl ketone (3 parts by volume) and methyl ethyl ketone (1 part by volume) was used to develop the bottom resist layer. Excellent 1 micrometer images were obtained. A slight residue was observed in scattered areas. Rinsing in a dilute aqueous solution of tetramethylammonium hydroxide (about 0.1N) followed by a water rinse removed all residues.

Example 4

Silicon wafers which had considerable topography (about 0.8 nm steps) which were covered with an evaporated film of aluminum plus 3 weight % copper, were used to determine the effect of reflective substrates on the process of this invention. The procedures of Example 1 were used except that the bottom resist layer was development processed as described in Example 3 and additionally 3% by weight of a coumarin dye (coumarin 7) was added to the bottom resist during resist material production. Excellent images, free of reflectivity effects, were obtained.

While the invention has been described in detail and with reference to specific embodiments thereof, it will be apparent to one skilled in the art that various changes and modifications can be made therein without departing from the spirit and scope thereof.

Claims

1. A method of producing a resist image comprising the steps of:

(a) providing a substrate with a layer of resist material as a bottom resist layer and with a layer of a wet developable resist material as a top resist layer, wherein

(i) the sensitivity to radiation of the resist material of the top resist layer differs significantly from the sensitivity to radiation of the resist material of the bottom resist layer, and

(ii) the resist material of the top resist layer contains sites capable of reacting with a silylating agent;

(b) imagewise exposing to radiation the top resist layer, the imagewise exposing of the top resist layer being such that the bottom resist layer is substantially unaffected by said imagewise exposing;

(c) wet developing the top resist layer to produce a top layer image;

(d) reacting the developed top resist layer with a silylating agent to produce an etch resistant pattern of the top resist layer on the bottom resist layer and also to render the top resist layer resistant to the development to be used for subsequent development of the bottom resist layer;

(e) exposing the bottom resist layer through the top layer resist image to radiation capable of rendering the resist material of the bottom resist layer in the exposed areas developable; and

(f) developing the exposed bottom resist layer to uncover the substrate in the imagewise exposed and developed areas.

characterized in that the resist material of the bottom resist layer is a wet developable resist selected in the group including (i) a copolymer of methylmethacrylate with methacrylic acid or methacrylic anhydride (ii) a terpolymer of methylmethacrylate, methacrylic acid and methacrylic anhydride.

2. The method of Claim 1, wherein the silylating agent is a multifunctional silizane.

3. The method of Claim 2, wherein the silylating agent is hexamethylcyclotrisilizane.

## Patentansprüche

1. Verfahren zur Herstellung eines Resistbildes, enthaltend die folgenden Schritte:

(a) Bereitstellung eines Substrats mit einer Schicht aus Resistmaterial als eine unterste Resistschicht und mit einer Schicht aus nassentwickelbarem Resistmaterial als eine oberste Resistschicht, worin

(i) die Strahlungsempfindlichkeit des Resistmaterials der obersten Resistschicht sich auf signifikante Weise von der Strahlungsempfindlichkeit des Resistmaterials der untersten Resistschicht unterscheidet, und

(ii) das Resistmaterial der obersten Resistschicht Stellen enthält, die in der Lage sind, mit einem silyl-bildenden Mittel eine Reaktion einzugehen;

(b) Bildweise Bestrahlung der obersten Resistschicht, wobei die bildweise Bestrahlung der obersten Resistschicht derart ist, dass die unterste Resistschicht im wesentlichen von der genannten bildweisen Bestrahlung unberührt ist;

(c) Nassentwicklung der obersten Resistschicht zur Herstellung eines obersten Schichtbildes;

(d) Eingehen einer Reaktion der entwickelten obersten Resistschicht mit einem silylbildenden Mittel, um ein ätzfestes Muster der obersten Resistschicht auf der untersten Resistschicht herzustellen und auch um die oberste Resistschicht widerstandsfähig zu machen gegenüber der Entwicklung, welche zur nachfolgenden Entwicklung der untersten Resistschicht anzuwenden ist;

(e) Bestrahlung der untersten Resistschicht durch das Resistbild der obersten Schicht hindurch, welche fähig ist, das Resistmaterial der untersten Resistschicht in den bestrahlten Bereichen entwickelbar zu machen; und

(f) Entwicklung der bestrahlten untersten Resistschicht, um das Substrat in den bildweise bestrahlten und entwickelten Bereichen freizulegen, dadurch gekennzeichnet, dass das Resistmaterial der untersten Resistschicht ein nassentwickelbarer Resist ist, das aus der Gruppe, welche (i) ein Copolymer von Methylmethacrylat mit Methacrylsäure oder Methacrylanhydrid oder (ii) ein Terpolymer von Methylmethacrylat, Methacrylsäure und Methacrylanhydrid beinhaltet, ausgewählt wurde.

2. Verfahren nach Anspruch 1, worin das silylbildende Mittel ein Mehrfunktionssilizan ist.

3. Verfahren nach Anspruch 2, worin das silylbildende Mittel Hexamethylzyklotrisilizan ist.

## Revendications

1. Procédé pour produire une image de réserve comprenant les étapes de:

(a) dépôt sur un substrat d'une couche de matière de réserve constituant une couche de réserve inférieure et d'une couche d'une matière de réserve développable par voie humide constituant une couche de réserve supérieure, dans lesquelles

(i) la sensibilité à un rayonnement de la matière de réserve de la couche de réserve supérieure diffère notablement de la sensibilité à un rayonnement de la matière de réserve de la couche de réserve inférieure, et

(ii) la matière de réserve de la couche de réserve supérieure contient des sites capables de réagir avec un agent silylant;

(b) exposition de la couche de réserve supérieure à un rayonnement formant une image, l'exposition selon une image de la couche de réserve supérieure étant telle que la couche de réserve inférieure n'est pratiquement pas affectée par cette exposition formant une image;

(c) développement par voie humide de la couche de réserve supérieure pour produire une image dans la couche supérieure;

(d) réaction de la couche de réserve supérieure développée avec un agent silylant pour produire un motif résistant à l'attaque de la couche de réserve supérieure sur la couche de réserve inférieure et aussi pour rendre la couche de réserve supérieure capable de résister au développement mis en oeuvre pour développer ultérieurement la couche de réserve inférieure;

(e) exposition de la couche de réserve inférieure à travers l'image de réserve de la couche supérieure, à un rayonnement capable de rendre développable la matière de réserve de la couche de réserve inférieure dans les zones exposées; et

(f) développement de la couche de réserve inférieure exposée pour découvrir le substrat dans les zones exposées selon une image et développées, caractérisé en ce que la matière de réserve de la couche de réserve inférieure est une réserve développable par voie humide choisie dans le groupe comprenant (i) un copolymère de méthacrylate de méthyle et d'acide méthacrylique ou d'anhydride méthacrylique, ou (ii) un terpolymère de méthacrylate de méthyle, d'acide méthacrylique et d'anhydride méthacrylique.

2. Procédé suivant la revendication 1, caractérisé en ce que l'agent silylant est un silizane multifonctionnel.

3. Procédé suivant la revendication 2, caractérisé en ce que l'agent silylant est l'hexaméthylcyclotrisilizane.